# EUROPÄISCHE PATENTANMELDUNG

(11) **EP 3 852 214 A1**
(43) Veröffentlichungstag der Anmeldung: **21.07.2021**
(21) Anmeldenummer: 20208997.5
(22) Anmeldetag: 20.11.2020
(51) Int. Cl.: H02J 3/38

(54) **VERFAHREN ZUM STEUERN EINER WINDENERGIEANLAGE**

(30) Priorität: 14.01.2020 DE 102020100715
(71) Anmelder: Wobben Properties GmbH, 26607 Aurich (DE)
(72) Erfinder: MACKENSEN, Ingo, 26607 Aurich (DE); GERTJEGERDES, Stefan, 26603 Aurich (DE); STRAFIEL, Christian, 26607 Aurich (DE)
(74) Vertreter: Eisenführ Speiser

(57) **Zusammenfassung**

Die vorliegende Erfindung betrifft ein Verfahren zum Steuern einer Windenergieanlage, umfassend die Schritte: Erfassen einer Netzspannung eines elektrischen Versorgungsnetzes, Einstellen einer Zwischenkreisspannung an einem Umrichter der Windenergieanlage in Abhängigkeit der erfassten Netzspannung und unter Verwendung einer ersten Zeitkonstanten und einer zweiten Zeitkonstanten, wobei die erste Zeitkonstante von der zweiten Zeitkonstanten verschieden ist.

## Beschreibung

Die Erfindung betrifft ein Verfahren zum Steuern einer Windenergieanlage sowie eine solche Windenergieanlage.

Üblicherweise speisen Windenergieanlagen die aus dem Wind erzeugte elektrische Leistung mittels eines Umrichters in das elektrische Versorgungsnetz ein.

Dabei kann es zu Rückwirkungen aus dem elektrischen Versorgungsnetz auf den Umrichter kommen, und dort insbesondere auf die Zwischenkreisspannung des Umrichters.

So kann es beispielsweise dazu kommen, dass diese Rückwirkungen dazu führen, dass die Zwischenkreisspannung des Umrichters stark schwankt, wodurch der Umrichter nicht mehr optimal arbeitet bzw. nicht mehr in einem optimalen Arbeitspunkt betrieben werden kann.

Solche Rückwirkungen können insbesondere in weichen elektrischen Versorgungsnetzen auftreten, also elektrischen Versorgungsnetzen mit einem geringen Kurzschlussleistungsverhältnis (kurz: SCR).

Das Deutsche Patent- und Markenamt hat in der Prioritätsanmeldung zur vorliegenden Anmeldung folgenden Stand der Technik recherchiert: WO 2011/160643 A2 und DE 10 2018 100 084 A1.

Aufgabe der vorliegenden Erfindung ist es daher, zumindest eines der obengenannten Probleme zu adressieren, insbesondere soll eine Lösung vorgeschlagen werden, die zu einer Optimierung bzw. Glättung der Zwischenkreisspannung und somit zu einer Verstetigung der Ausgangsgrößen eines Umrichters einer Windenergieanlage führt, bevorzugt auch dann, wenn die Windenergieanlage an ein weiches elektrisches Versorgungnetz angeschlossen ist. Zumindest soll aber eine Alternative zur bisher bekannten Lösung vorgeschlagen werden.

Erfindungsgemäß wird somit ein Verfahren zum Steuern einer Windenergieanlage vorgeschlagen, umfassend die Schritte: Erfassen einer Netzspannung eines elektrischen Versorgungsnetzes und Einstellen einer Zwischenkreisspannung an einem Umrichter der Windenergieanlage in Abhängigkeit der erfassten Netzspannung und unter Verwendung einer ersten Zeitkonstanten und einer zweiten Zeitkonstanten, wobei die erste Zeitkonstante von der zweiten Zeitkonstanten verschieden ist.

Es wird somit insbesondere vorgeschlagen, den Umrichter einer Windenergieanlage in Abhängigkeit von einer erfassten Netzspannung eines elektrischen Versorgungnetzes zu betreiben, insbesondere mittels einer Arbeitspunktabhängigen Zwischenkreisspannung.

Das Einstellen der Zwischenkreisspannung erfolgt dabei in Abhängigkeit von einer erfassten Netzspannung und bevorzugt eines bzw. des Arbeitspunktes des Umrichters.

Die erste Zeitkonstante und die zweite Zeitkonstante haben die Aufgabe, die direkte Kopplung zwischen der arbeitspunktabhängigen Zwischenkreisspannung und der Netzspannung des elektrischen Versorgungnetzes zu dämpfen, insbesondere so, dass der Einfluss der Netzspannung auf die Zwischenkreisspannung abgemildert wird.

Hierzu wird erfindungsgemäß insbesondere vorgeschlagen, dass die erste Zeitkonstante von der zweiten Zeitkonstante verschieden ist. Bspw. beträgt die erste Zeitkonstante weniger als 0,1 Sekunde und die zweite Zeitkonstante ca. 1 Sekunde.

Dies bedeutet insbesondere, dass der Einfluss der Netzspannung auf die Zwischenkreisspannung für einen Anstieg bzw. einen Abfall der Netzspannung unterschiedlich behandelt wird.

Es wird also insbesondere vorgeschlagen, dass der Umrichter, und dort insbesondere die Zwischenkreisspannung, zwischen einem Netzspannungsanstieg des elektrischen Versorgungnetzes und einem Netzspannungsabfall des elektrischen Versorgungnetzes unterscheidet bzw. differenziert.

Hierzu wird insbesondere vorgeschlagen, dass bei einem Anstieg der Netzspannung ein direkter Anstieg der Zwischenkreisspannung erfolgt, und dass bei einem Abfall der Netzspannung eine langsame Absenkung der Zwischenkreisspannung erfolgt.

Es wird also insbesondere auch vorgeschlagen, dass der Umrichter mit zwei unterschiedlichen Gradienten betrieben wird, nämlich einem steilen Gradienten für die Zwischenkreisspannung bei einem Anstieg der Netzspannung und einem flachen Gradienten für die Zwischenkreisspannung bei einem Abfall der Netzspannung.

Hierdurch ist es insbesondere möglich, die Ausgangsgrößen eines Umrichters einer Windenergieanlage so zu optimieren, dass die Windenergieanlage auch an ein weiches elektrisches Versorgungnetz angeschlossen werden kann, insbesondere ohne dass sich die Windenergieanlage bzw. ohne dass sich das Betriebsverhalten der Windenergieanlage negativ auf das elektrische Versorgungsnetz auswirkt.

Unter einem weichen Versorgungsnetz werden dabei insbesondere Netzabschnitte und/oder Netzanschlusspunkte verstanden, die empfindlich auf Änderungen der Einspeisung der Erzeuger reagieren, also bspw. Netzanschlusspunkte mit einer short circuit ration (kurz: SCR) kleiner als 6 oder kleiner als 4.

Vorzugsweise umfasst das Verfahren zum Steuern einer Windenergieanlage ferner den Schritt: Feststellen einer positiven oder negativen Netz-Spannungsänderung in Abhängigkeit der erfassten Netzspannung, wobei die erste Zeitkonstante einer positiven Netz-Spannungsänderung zugeordnet ist und die zweite Zeitkonstante einer negativen Netz-Spannungsänderung zugeordnet ist.

Es wird also insbesondere vorgeschlagen, dass das Erfassen der Netzspannung, insbesondere ständig, wiederholt wird und, dass aus den so erfassten Netzspannungen eine Spannungsänderung der Netzspannung des elektrischen Versorgungsnetzes ermittelt wird. Diese Spannungsänderung der Netzspannung des elektrischen Versorgungsnetzes kann auch als Netz-Spannungsänderung bezeichnet werden.

Bevorzugt wird zudem zwischen einer positiven und einer negativen Netzspannungsänderung unterschieden.

Zudem ist jeder positiven Netzspannungsänderung die erste Zeitkonstante zugeordnet und jeder negativen Netzspannungsänderung die zweite Zeitkonstante zugeordnet.

Es wird also insbesondere auch vorgeschlagen, dass die erste und die zweite Zeitkonstante unabhängig von dem Betrag der Spannungsänderung verwendet wird, beispielsweise beträgt die erste Zeitkonstante 0 Sekunden für alle positiven Netzspannungsänderungen und 0,5 Sekunden für alle negativen Netzspannungsänderungen.

Durch eine solche Wahl der Zeitkonstanten ist es insbesondere möglich, die direkte Kopplung zwischen der arbeitspunktabhängigen Zwischenkreisspannung und der Netzspannung zu dämpfen, insbesondere wird so der Einfluss der Netzspannung auf die Zwischenkreisspannung reduziert.

Zudem wurde erfindungsgemäß erkannt, dass bei richtiger Wahl der Zeitkonstanten, wie vorstehend oder nachstehend beschrieben, zu einer Glättung der Zwischenkreisspannung kommt, wodurch der Umrichter optimalere Arbeitspunkte aufweist.

Vorzugsweise umfasst das Verfahren zum Steuern einer Windenergieanlage ferner den Schritt: Erfassen einer Netzimpedanz einer Netzdrossel, wobei die Zwischenkreisspannung zusätzlich in Abhängigkeit der erfassten Impedanz eingestellt wird.

Es wird also auch vorgeschlagen, die Impedanz einer etwaigen Netzdrossel, welche am Ausgang des Umrichters angeordnet sein kann, ebenfalls zu berücksichtigen.

Vorzugsweise umfasst das Verfahren zum Steuern einer Windenergieanlage ferner den Schritt: Erfassen eines Phasenwinkels und/oder einer Amplitude eines einzuspeisenden Stromes, wobei die Zwischenkreisspannung zusätzlich in Abhängigkeit des erfassten Phasenwinkels und/oder der erfassten Amplitude des einzuspeisenden Stromes eingestellt wird.

Es wird also ferner auch vorgeschlagen, den Phasenwinkel und/oder die Amplitude des einzuspeisenden Stromes zu berücksichtigen.

In einer besonders bevorzugten Ausführungsform wird somit vorgeschlagen, dass die Zwischenkreisspannung in Abhängigkeit von einer Netz-Spannungsänderung des elektrischen Versorgungsnetzes, der Impedanz der Netzdrossel, dem Phasenwinkel und der Amplitude des einzuspeisenden Stromes eingestellt wird.

Vorzugsweise liegt die erste Zeitkonstante in einem Bereich zwischen 0 und 1 Sekunden, bevorzugt unterhalb von 0,2 Sekunden, besonders bevorzugt beträgt die erste Zeitkonstante im Wesentlichen 0 Sekunden.

Es wird also insbesondere auch vorgeschlagen, dass es bei einem Anstieg der Netzspannung zu einem direkten Anstieg der Zwischenkreisspannung kommt.

Vorzugsweise liegt die zweite Zeitkonstante in einem Bereich zwischen 0 und 5 Sekunden, bevorzugt zwischen 0,5 und 4 Sekunden, besonders bevorzugt oberhalb von 1 Sekunde.

Es wird also insbesondere vorgeschlagen, dass bei einem Abfall der Netzspannung die Zwischenkreisspannung nur langsam nachgeführt wird, bevorzugt mittels eines flachen Gradienten nachgeführt wird.

Die Zwischenkreisspannung des Umrichters wird also so gesteuert, dass bei einem Abfall der Netzspannung die Zwischenkreisspannung zeitverzögert reagiert.

Erfindungsgemäß wird ferner die Verwendung eines vorstehenden oder nachstehenden Verfahrens in einer Windenergieanlage vorgeschlagen, die mit einem elektrischen Versorgungnetz verbunden ist, welches eine verhältnismäßig hohe Netzimpedanz aufweist und/oder als weiches Netz ausgebildet ist und/oder ein geringes Kurzschlussleistungsverhältnis aufweist, insbesondere einen SCR kleiner als 6.

Es wird somit auch vorgeschlagen, dass vorstehende oder nachstehend beschriebene Verfahren insbesondere bei Windenergieanlagen zu verwenden, die an einem weichen elektrischen Versorgungsnetz angeschlossen sind.

Vorzugsweise ist also die Windenergieanlage mit einem elektrischen Versorgungnetz verbunden, welches eine verhältnismäßig hohe Netzimpedanz aufweist und/oder als weiches Netz ausgebildet ist und/oder ein geringes Kurzschlussstromverhältnis (kurz: SCR) aufweist.

Erfindungsgemäß wird ferner eine Windenergieanlage vorgeschlagen, umfassend: einen, einen Zwischenkreis mit einer Zwischenkreisspannung aufweisenden Umrichter, der dazu eingerichtet ist, elektrische Leistung in Abhängigkeit einer erfassten Netzspannung in ein elektrisches Versorgungsnetz einzuspeisen und eine Steuereinheit, die wenigstens dazu eingerichtet ist, eine Netzspannung eines elektrischen Versorgungsnetzes zu erfassen und die Zwischenkreisspannung unter Verwendung einer ersten und einer zweiten Zeitkonstanten einzustellen.

Es wird also insbesondere vorgeschlagen, dass das vorstehend oder nachstehend beschriebene Verfahren durch eine Steuereinheit ausgeführt wird, die bevorzugt die beschriebenen Zeitkonstanten dazu verwendet, die Zwischenkreisspannung eines Umrichters einzustellen.

Vorzugsweise ist die Steuereinheit ferner dazu eingerichtet, festzustellen, ob eine positive oder negative Netzspannungsänderung innerhalb des elektrischen Versorgungnetzes vorliegt.

Vorzugsweise umfasst die Windenergieanlage ferner Mittel, die dazu eingerichtet sind, einen Phasenwinkel eines einzuspeisenden Stromes und/oder einer Amplitude eines einzuspeisenden Stromes zu erfassen.

Dies können beispielsweise Messgeräte oder Messinstrumente sein, die am Ausgang des Umrichters angeordnet sind, also zwischen Umrichter und dem elektrischen Versorgungnetz.

Vorzugsweise ist die Steuereinheit ferner dazu eingerichtet, ein vorstehend oder nachstehend beschriebenes Verfahren auszuführen.

Vorzugsweise ist der Umrichter Bestandteil eines Vollumrichterkonzeptes der Windenergieanlage und die Zwischenkreisspannung des Umrichters wird mittels eines Hochsetzstellers und/oder eines Gleichspannungswandlers eingestellt.

Es wird insbesondere also auch vorgeschlagen, dass die Windenergieanlage eine Windenergieanlage mit Vollumrichterkonzept ist, wie beispielsweise nachstehend beschrieben.

Die vorliegende Erfindung wird nun nachfolgend exemplarisch und anhand von Ausführungsbeispielen unter Bezugnahme auf die begleitenden Figuren näher erläutert, wobei für gleiche oder ähnliche Bauteile gleiche Bezugszeichen verwendet werden. Hierbei zeigen:
- Fig. 1: schematisch und exemplarisch eine perspektivische Ansicht einer Windenergieanlage in einer Ausführungsform,
- Fig. 2: schematisch und exemplarisch einen Aufbau eines elektrischen Stranges einer erfindungsgemäßen Windenergieanlage und
- Fig. 3: schematisch und exemplarisch den Verlauf einer Zwischenkreisspannung eines Wechselrichters, welcher mit einem erfindungsgemäßen Verfahren betrieben wird, in Abhängigkeit einer Netzspannung.

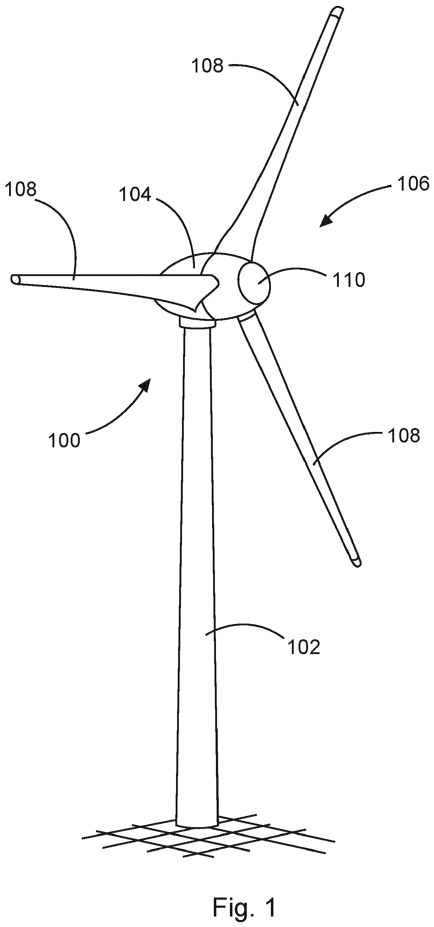

Fig. 1 zeigt eine perspektivische Ansicht einer Windenergieanlage 100.

Die Windenergieanlage 100 weist hierzu einen Turm 102 und eine Gondel 104 auf. An der Gondel 104 ist ein aerodynamischer Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel an. Der Generator erzeugt hierdurch einen einzuspeisenden Strom, der mittels eines Wechselrichters in ein elektrisches Versorgungnetz eingespeist wird.

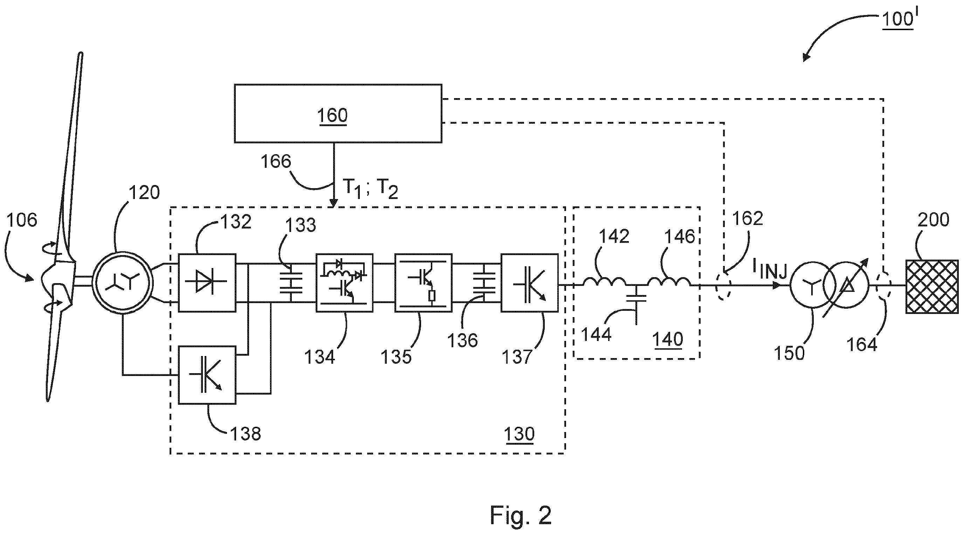

Fig. 2 zeigt schematisch und exemplarisch einen elektrischen Strang 100' einer erfindungsgemäßen Windenergieanlage 100, wie bevorzugt in Figur 1 gezeigt.

Der aerodynamische Rotor der Windenergieanlage 106 ist mit dem Generator 120 der Windenergieanlage verbunden. Bevorzugt ist der Generator 120 dabei als sechsphasiger Ringgenerator ausgebildet.

Der Generator 120 ist ferner über einen Umrichter 130 mittels einer Netzschutzeinrichtung 140 und eines Transformators 150 mit einem elektrischen Versorgungsnetz 200 verbunden bzw. an das elektrische Versorgungsnetz 200 angeschlossen.

Um die vom Generator 120 erzeugte elektrische Leistung in einen einzuspeisenden Strom I_{INJ} umzuwandeln, weist der Umrichter 130 am Umrichtereingang einen Gleichrichter 132 auf. Der Gleichrichter 132 ist zudem mit einem ersten Gleichspannungszwischenkreis 133 verbunden. Der erste Gleichspannungszwischenkreis 133 wiederum ist mit einem Hochsetzsteller 134 verbunden. Der Hochsetzsteller 134 ist wiederum mit einem Chopper 135 verbunden. Der Chopper 135 ist wiederum mit einem zweiten Gleichspannungszwischenkreis 136 verbunden. Der zweite Gleichspannungszwischenkreis 136 ist wiederum mit einem Wechselrichter 137 verbunden. Der Wechselrichter 137 selbst bildet dabei den Umrichterausgang aus, welcher mit einer Netzschutzeinrichtung 140 versehen ist.

Die Netzschutzeinrichtung 140 umfasst beispielsweise eine Entkopplungsdrossel 142, einen Filter 144 und eine Netzdrossel 146. In einer bevorzugten Ausführungsform ist die Netzschutzeinrichtung 140 also als LCL-Filter ausgebildet.

Um den einzuspeisenden Strom I_{INJ} in das elektrische Versorgungnetz 200 einzuspeisen, ist ferner ein Windenergieanlagentransformator 150 vorgesehen, der bevorzugt im SternDreieck geschaltet ist.

Das elektrische Versorgungsnetz 200, an das die Windenergieanlage 100 mittels des Transformators 150 angeschlossen ist, kann beispielsweise ein Windparknetz sein oder ein elektrisches Versorgungs- oder Verteilnetz.

Zum Steuern des elektrischen Stranges 100' ist ferner eine Steuereinheit 160 vorgesehen.

Die Steuereinheit 160 ist dazu eingerichtet, den einzuspeisenden Strom I_{INJ} mittels eines Stromerfassungsmittels 162 zu erfassen. Zudem weist die Steuereinheit auch Spannungserfassungsmittel 164 auf, die dazu eingerichtet sind, eine Netzspannung des elektrischen Versorgungnetzes 200 zu erfassen.

In einer besonders bevorzugten Ausführungsform ist die Steuereinheit 160 zudem dazu eingerichtet, auch den Phasenwinkel und die Amplitude des einzuspeisenden Stromes I_{INJ} zu erfassen.

In einer weiteren Ausführungsform ist die Steuereinheit auch dazu eingerichtet, die Impedanz der Netzschutzeinrichtung 140 zu ermitteln. Dies kann beispielsweise über eine Messung erfolgen, oder durch eine Parametrierung der Steuereinheit 160.

Aus den so erfassten Werten, also bspw. der Netzspannung und dem Phasenwinkel, bestimmt die Steuereinheit anschließend die erfindungsgemäßen Zeitkonstanten T1 und T2, welche mittels einer Signalleitung 166 an den Umrichter 130 übergeben werden. Alternativ können die Zeitkonstanten auch berechnet oder simuliert und anschließend in der Windenergieanlage parametriert werden.

Es ist aber auch denkbar, dass der Umrichter 130 einen aktiven Gleichrichter aufweist, der die Funktionsweise der Bauteile 132,133, 134 in sich vereinigt, sodass dann die Zeitkonstanten T1 und T2 dazu verwendet werden, diesen aktiven Gleichrichter anzusteuern. Ferner weist der Umrichter 130 eine Erregerstromeinheit 138 auf, die dazu eingerichtet ist, einen Erregerstrom für den Generator 120 aus dem Zwischenkreis 133 bereitzustellen.

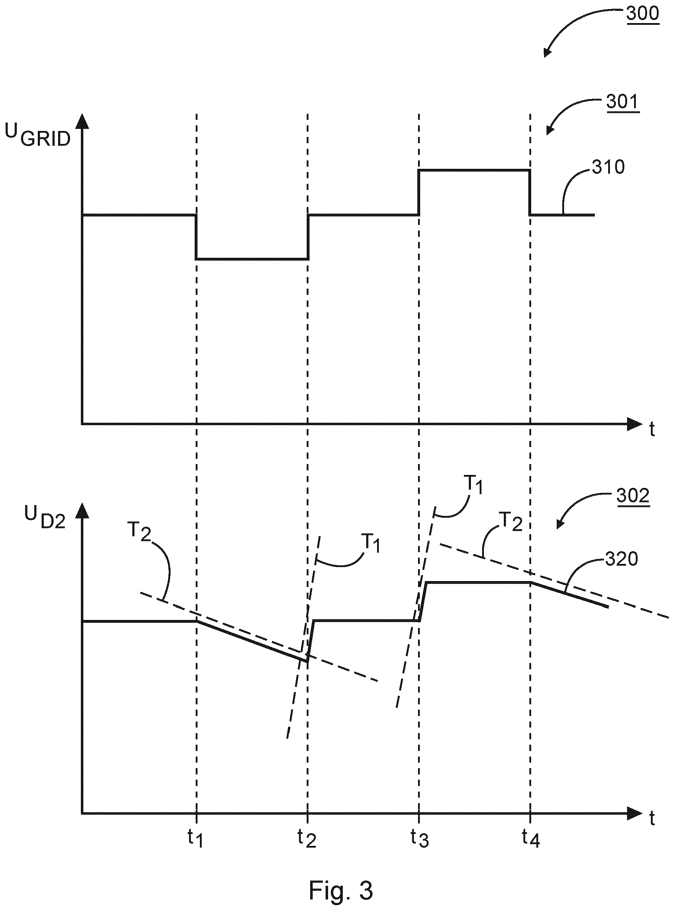

Die aus einem solchen Aufbau resultierenden Funktionsweisen werden nun nachfolgend anhand von Fig. 3 beschrieben.

Fig. 3 zeigt schematisch und exemplarisch den Verlauf einer Zwischenkreisspannung eines Wechselrichters einer Windenergieanlage in Abhängigkeit einer erfassten Netzspannung unter Verwendung des erfindungsgemäßen Verfahrens.

In einem oberen Diagramm 301 ist die Netzspannung des elektrischen Versorgungsnetzes U_{grid} über der Zeit abgetragen.

In einem unteren Diagramm 302 ist die Zwischenkreisspannung U_{D2} über der Zeit abgetragen. Bevorzugt ist die Zwischenkreisspannung U_{D2} die Zwischenkreisspannung eines zweiten Gleichspannungszwischenkreises 136, wie insbesondere in Figur 1 gezeigt.

Der Zeitverlauf der Diagramme 301 und 302 ist im Wesentlichen zeitsynchron. Dies ist durch die gestrichelten Linie t1, t2, t3, t4, t5 angedeutet.

Der Graph 310 im oberen Diagramm 301 zeigt dabei den Verlauf der Netzspannung U_{grid} des elektrischen Versorgungnetzes.

Zum Zeitpunkt t1 bricht diese Netzspannung U_{grid} ein, woraufhin die Zwischenkreisspannung U_{D2}, die durch den Graphen 320 im unteren Diagramm 302 angedeutet ist, langsam mittels der Zeitkonstanten T1 abgesenkt wird.

Zum Zeitpunkt t2 erholt sich die Netzspannung U_{grid} wieder, bzw. steigt auf ihr ursprüngliches Niveau an, woraufhin die Zwischenkreisspannung U_{D2} direkt wieder mittels der Zeitkonstante T2 angehoben wird.

Zum Zeitpunkt t3 steigt die Netzspannung U_{grid} des elektrischen Versorgungnetzes schlagartig an, woraufhin ebenfalls die Zwischenkreisspannung U_{D2} direkt wieder mittels der Zeitkonstanten T2 angehoben wird.

Zum Zeitpunkt t4 fällt die Netzspannung U_{grid} wieder auf ihr ursprüngliches Niveau ab, woraufhin die Zwischenkreisspannung UD2 wieder langsam mittels der Zeitkonstanten T1 abgesenkt wird.

Der direkte Anstieg der Zwischenkreisspannung U_{D2} zu den Zeitpunkten t2 und t3 wird dabei durch die ZeitkonstanteT1 hervorgerufen, die im Wesentlichen 0 Sekunden beträgt.

Die langsame Absenkung der Zwischenkreisspannung ab den Zeitpunkten t1 und t4 wird dabei durch die zweite Zeitkonstante T2 hervorgerufen, die im Wesentlichen auf einen Wert im Bereich zwischen 0,5 und 4 Sekunden eingestellt ist.

Durch eine solche Parametrierung der Zeitkonstanten T1 und T2, ist es möglich, die Zwischenkreisspannung zu glätten.

Es wurde nämlich erfindungsgemäß erkannt, dass eines solche Ausführung der Zeitkonstanten T1 und T2 zu einer besseren Qualität des einzuspeisenden Strom I_{INJ} führt.

Dies ermöglicht insbesondere einen Betrieb von Windenergieanlagen in Netzen mit Störquellen (z.B. große Stahlfabriken), in Netzen mit kleinem SCR und/oder einen größeren Sicherheitsabstand zu Stabilitätsgrenzen des elektrischen Versorgungsnetzes und/oder der Windenergieanlage.

## Patentansprüche

1. Verfahren zum Steuern einer Windenergieanlage, umfassend die Schritte:
- Erfassen einer Netzspannung eines elektrischen Versorgungsnetzes,
- Einstellen einer Zwischenkreisspannung an einem Umrichter der Windenergieanlage in Abhängigkeit der erfassten Netzspannung und unter Verwendung einer ersten Zeitkonstanten und einer zweiten Zeitkonstanten, wobei
- die erste Zeitkonstante von der zweiten Zeitkonstanten verschieden ist.

2. Verfahren zum Steuern einer Windenergieanlage, ferner umfassend den Schritt:
- Feststellen einer positiven oder negativen Netz-Spannungsänderung in Abhängigkeit der erfassten Netzspannung, wobei
- die erste Zeitkonstante einer positiven Netz-Spannungsänderung zugeordnet ist und
- die zweite Zeitkonstante einer negativen Netz-Spannungsänderung zugeordnet ist.

3. Verfahren zum Steuern einer Windenergieanlage nach Anspruch 1 oder 2, ferner umfassend den Schritt:
- Erfassen einer Impedanz einer Netzdrossel, wobei
- die Zwischenkreisspannung zusätzlich in Abhängigkeit der erfassten Impedanz eingestellt wird.

4. Verfahren zum Steuern einer Windenergieanlage nach einem der vorstehenden Ansprüche, ferner umfassend den Schritt:
- Erfassen eines Phasenwinkels und/oder einer Amplitude eines einzuspeisenden Stromes, wobei
- die Zwischenkreisspannung zusätzlich in Abhängigkeit des erfassten Phasenwinkels und/oder der erfassten Amplitude des einzuspeisenden Stromes eingestellt wird.

5. Verfahren zum Steuern einer Windenergieanlage nach einem der vorstehenden Ansprüche, wobei
- die erste Zeitkonstante in einem Bereich zwischen 0 und 1 Sekunden liegt, bevorzugt unterhalb von 0,2 Sekunden, besonders bevorzugt beträgt die erste Zeitkonstante im Wesentlichen 0 Sekunden.

6. Verfahren zum Steuern einer Windenergieanlage nach einem der vorstehenden Ansprüche, wobei
- die zweite Zeitkonstante in einem Bereich zwischen 0 und 5 Sekunden liegt, bevorzugt zwischen 0,5 und 4 Sekunden, besonders bevorzugt größer 1.

7. Verwendung eines Verfahrens nach einem der Ansprüche 1 bis 6 in einer Windenergieanlage, die mit einem elektrischen Versorgungsnetz verbunden ist, welches eine verhältnismäßig hohe Netzimpedanz aufweist und/oder als weiches Netz ausgebildet ist und/oder ein geringes Kurzschlussleistungsverhältnis aufweist, insbesondere einen SCR < 6.

8. Windenergieanlage, wenigstens umfassend:
- einen, einen Zwischenkreis mit einer Zwischenkreisspannung aufweisenden Umrichter, der dazu eingerichtet ist, elektrische Leistung in Abhängigkeit einer erfassten Netzspannung in ein elektrisches Versorgungsnetz einzuspeisen und
- eine Steuereinheit, die wenigstens dazu eingerichtet ist:
- eine Netzspannung eines elektrischen Versorgungsnetzes zu erfassen,
- die Zwischenkreisspannung unter Verwendung einer ersten und einer zweiten Zeitkonstanten einzustellen.

9. Windenergieanlage nach Anspruch 8, wobei
- die Steuereinheit ferner dazu eingerichtet ist,
- festzustellen, ob eine positive oder negative Netz-Spannungsänderung innerhalb des elektrischen Versorgungsnetzes vorliegt.

10. Windenergieanlage nach einem der vorstehenden Ansprüche, ferner umfassend Mittel, die dazu eingerichtet sind, einen Phasenwinkel eines einzuspeisenden Stromes und/oder eine Amplitude eines einzuspeisenden Stromes zu erfassen.

11. Windenergieanlagen nach einem der vorstehenden Ansprüche, wobei
- die Steuereinheit ferner dazu eingerichtet ist, ein Verfahren nach einem der vorstehenden Ansprüche auszuführen.

12. Windenergieanlage nach einem der vorstehenden Ansprüche, wobei der Umrichter Bestandteil eines Vollumrichterkonzeptes ist und die Zwischenkreisspannung mittels eines Hochsetzstellers oder eines Gleichspannungswandlers eingestellt wird.
